Europäisches Patentamt

European Patent Office

Office européen des brevets

(11) Veröffentlichungsnummer: **0 068 270**
A1

# EUROPÄISCHE PATENTANMELDUNG

(21) Anmeldenummer: 82105199.2

(22) Anmeldetag: 14.06.82

(51) Int. Cl.³: **H 01 R 23/72, G 01 R 1/073**

(30) Priorität: 15.06.81 DE 3123627

(43) Veröffentlichungstag der Anmeldung: 05.01.83
Patentblatt 83/1

(84) Benannte Vertragsstaaten: AT BE CH DE FR GB IT LI LU NL SE

(71) Anmelder: SIEMENS AKTIENGESELLSCHAFT Berlin
und München, Postfach 22 02 61,
D-8000 München 22 (DE)

(72) Erfinder: Brabetz, Bernhard, Dipl.-Ing., Dr.
Böttcher-Strasse 33, D-8000 München 60 (DE)
Erfinder: Sievers, Werner, Schillerstrasse 18,
D-8902 Neusaess (DE)
Erfinder: Urban, Simon, Dipl.-Ing., Linderhofstrasse 33,
D-8000 München 70 (DE)

(54) Vorrichtung zum gleichzeitigen Kontaktieren mehrerer eng beisammenliegender Prüfpunkte, insbesondere von Rasterfeldern.

(57) Zum gleichzeitigen Kontaktieren von mehreren Prüfpunkten, insbesondere von Rasterfeldern, werden in axialer Richtung federnde Kontaktstifte verwendet, wobei die Kontaktkraft jedes Kontaktstiftes von einer Schraubenfeder aufgebracht wird, die in einer Federkammer einer entsprechenden Platte angeordnet ist. Eine solche Vorrichtung kann nur dort verwendet werden, wo der Rasterabstand entsprechend groß ist. Der Erfindung liegt die Aufgabe zugrunde, eine Vorrichtung zu schaffen, mit der auch Rasterfelder mit kleinsten Rasterabständen adaptiert werden können. Dies wird gemäß der Erfindung dadurch erreicht, daß die Kontaktstifte (5) extrem dünn sind und aus Federmetall bestehen, wobei die Federkraft durch Ausknicken und/oder Ausfedern senkrecht zu axialen Bewegungsrichtung der Kontaktstifte (5) aufgebracht wird.

ACTORUM AG

SIEMENS AKTIENGESELLSCHAFT
Berlin und München

Unser Zeichen
VPA 81 P 7 0 5 6 E

Vorrichtung zum gleichzeitigen Kontaktieren mehrerer eng beisammenliegender Prüfpunkte, insbesondere von Rasterfeldern

Die Erfindung bezieht sich auf eine Vorrichtung zum gleichzeitigen Kontaktieren mehrerer eng beisammenliegender Prüfpunkte, insbesondere von Rasterfeldern mit kleinen Rasterabständen, mit Hilfe von in axialer Richtung federnden Kontaktstiften, die in einer Platte oder dgl. längsbeweglich und unter Federwirkung stehend entsprechend dem Rasterfeld oder dgl. angeordnet sind.

Vorrichtungen dieser Art dienen im wesentlichen zum gleichzeitigen Kontaktieren von mehreren Punkten, um diese auf Durchgang und Isolation gegeneinander hin überprüfen zu können. Wichtig hierbei ist, daß die einzelnen Kontaktstifte mit einer vorgegebenen Kontaktkraft auf den Prüfpunkten aufliegen. Bei den bekannten Vorrichtungen dieser Art wird der Kontaktdruck für jeden Kontaktstift durch eine Schraubenfeder aufgebracht, die in das System integriert ist. Die Schraubenfedern sind in Federkammern einer entsprechend ausgebildeten Platte untergebracht und umgeben die mit einem Kragen oder dgl. versehenen Kontaktstifte. Es ist leicht einzusehen, daß dieses Prinzip dann nicht mehr anwendbar ist, wenn die Rasterabstände so klein sind, daß die Schraubenfedern aus räumlichen Gründen nicht mehr untergebracht werden können. Dies ist z.B. dann der Fall, wenn die Rasterabstände das Maß von ca. 0,4 mm unterschreiten. Aber auch bei Rasterabständen im Bereich von 0,4 bis 1,2 mm ist es mit den bekannten Vorrichtungen nicht möglich, größere homogene Rasterfelder in einer Komplettadaptierung zu kontaktieren, da die Federkammern

Hs 1 Kow / 15.6.1981

der Schraubenfedern -auch bei Verwendung von flexiblen Taststiften- die Anzahl nebeneinander anordbarer Kontaktstifte begrenzen.

Der Erfindung liegt die Aufgabe zugrunde, eine Vorrichtung der eingangs beschriebenen Art derart auszubilden, daß auch Rasterfelder mit kleinsten Rasterabständen adaptiert werden können. Die Vorrichtung gemäß der Erfindung ist dadurch gekennzeichnet, daß die Kontaktstifte in Bezug auf ihre Länge extrem dünn ausgebildet sind und aus Federmetall bestehen und daß die in axialer Richtung wirkende Federkraft für jeden der Kontaktstifte durch Ausknicken und/oder Ausfedern der Kontaktstifte senkrecht zu ihrer axialen Bewegungsrichtung (Längsrichtung) beim Aufsetzen der Kontaktstifte auf das Rasterfeld aufgebracht wird.

Die Funktionsweise beruht darauf, daß die Biegeelastizität und Rückfederkraft in die gestreckte bzw. vorgegebene (Ruhe)Form der einzelnen Kontaktstifte benutzt werden, um eine sichere Kontaktierung eines jeden Einzelkontaktes durch individuelle Federkraft zu gewährleisten. Die dabei in axialer Richtung sich ergebende Verkürzung des Kontaktstiftes stellt den Federweg dar.

Im Falle der Verwendung eines geraden Kontaktstiftes beinhaltet das Kraft-Wegdiagramm jedes einzelnen Kontaktstiftes die Knickkraft. Um die Knickkraft ganz auszuschalten, ist es vorteilhaft, daß die Kontaktstifte zumindest vor dem Aufsetzen auf das Rasterfeld senkrecht zu ihrer axialen Bewegungsrichtung (Längsrichtung) elastisch vorbiegbar sind.

Eine besonders einfache Lösung ergibt sich dadurch, daß die Kontaktstifte senkrecht zu ihrer axialen Bewegungsrichtung (Längsrichtung) plastisch vorgebogen sind.

0068270

81 P 7 0 5 6 E

Vorzugsweise weist die erfindungsgemäße Vorrichtung mindestens zwei miteinander in Verbindung stehende, parallel zueinander angeordnete Platten auf, wobei die Kontaktstifte am hinteren Ende in der einen (oberen) Platte festgelegt und am vorderen Ende in der anderen (unteren) Platte durch entsprechend ausgebildete Bohrungen längsbeweglich geführt sind. Hierbei ist die Anzahl der Kontaktstifte entsprechend dem Rasterfeld frei wählbar. Bestimmend für die Positionsgenauigkeit der Kontaktstifte ist die untere Platte, die aus diesem Grunde mit hochgenauen Bohrungen zur Führung der Kontaktstifte versehen ist. Der Abstand der beiden Platten voneinander kann fest oder einstellbar sein. Letzteres kann zweckmäßig sein, wenn der Federweg und/oder die Kontaktkraft geändert werden soll. Die Größe des Abstandes der Platten voneinander ist zu wählen in Abhängigkeit von der Elastizität der Kontaktstifte, der gewünschten Kontaktkraft und dem erforderlichen individuellen Federweg der Kontaktstifte.

Anhand der Zeichnung, in der mehrere Ausführungsbeispiele schematisch dargestellt sind, wird die Erfindung näher erläutert. Es zeigen:

Figur 1 einen Teil einer Vorrichtung mit geraden Kontaktstiften ohne Belastung,

Figur 2 eine der Figur 1 entsprechende Darstellung bei Belastung der Kontaktstifte,

Figur 3 einen Teil einer Vorrichtung mit elastisch gebogenen Kontaktstiften,

Figur 4 einen Teil einer Vorrichtung mit im unbelasteten Zustand plastisch vorgebogenen Kontaktstiften,

Figur 5 eine der Figur 4 entsprechende Vorrichtung bei Belastung der Kontaktstifte,

Figur 6 einen Teil einer Vorrichtung mit vorgespannten Kontaktstiften und

0068270

Figur 7 einen Teil einer Vorrichtung mit elastisch gebogenen Kontaktstiften.

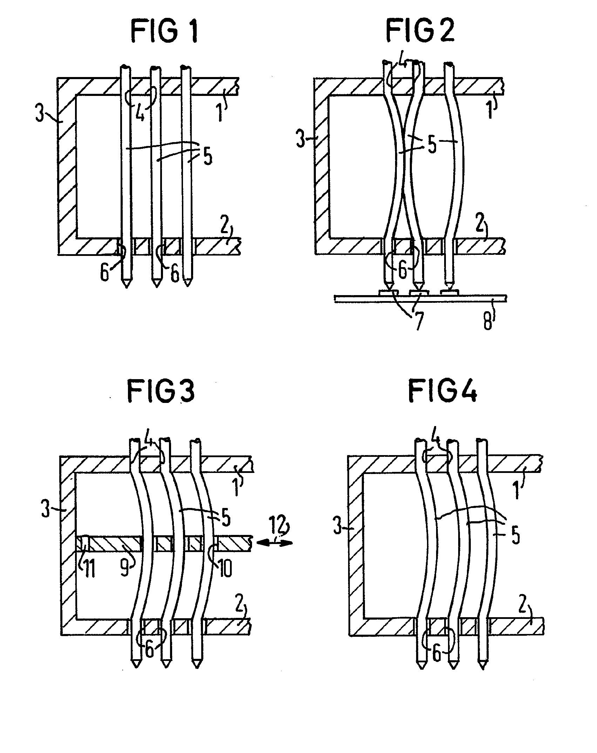

Die Vorrichtung besteht im Prinzip aus einer oberen Platte 1 und einer unteren Platte 2, die über ein Verbindungsstück 3 fest miteinander verbunden sind. Die Platten 1 und 2 sind zueinander parallel angeordnet. In der oberen Platte 1 sind Bohrungen 4 vorgesehen, deren Abstand voneinander dem Rasterabstand des zu kontaktierenden Rasterfeldes angepaßt ist. In den Bohrungen 4 sind Kontaktstifte 5 eingesetzt, die am oberen aus der oberen Platte 1 heraustretenden Enden in an sich bekannter Weise mit einer Meßeinheit, z.B. einer Prüfspannungsquelle oder dgl. verbunden sind. Entsprechend den Bohrungen 4 in der oberen Platte 1 weist auch die untere Platte 2 Bohrungen 6 auf, durch die sich die freien Enden der Kontaktstifte 5 erstrecken. Der Durchmesser der Bohrungen 6 zum Durchmesser der Kontaktstifte 5 ist so bemessen, daß sie möglichst spielfrei in den Bohrungen 6 geführt sind. Falls es erwünscht ist, daß die einzelnen Kontaktstifte 5 voneinander isoliert sind, können sie auf ihrer Länge zwischen den Platten 1 und 2 mit einer Isolierschicht überzogen sein, damit sie bei gegenseitiger Berührung elektrisch isoliert sind. Dieser Fall ist beispielsweise in Figur 2 angedeutet, wo die freien Enden der Kontaktstifte 5 von den Kontaktstellen 7 eines Prüflings 8 gedrückt und dadurch die Teile zwischen den Platten 1 und 2 ausgeknickt sind und sich gegenseitig berühren.

Beim Kontaktieren (Adaptieren) des Prüflings 8 wird dieser so unter die Vorrichtung gebracht, daß die freien Enden der Kontaktstifte 5 auf den zu kontaktierenden Kontaktstellen 7 des Prüflings 8 aufsetzen. Hierbei wird die Vorrichtung gefedert oder ungefedert gegen den Prüfling 8 gedrückt. Höhendifferenzen auf dem Prüfling 8 werden durch das individuelle Einfedern der Kontaktstifte 5 ausgeglichen. Dies wird ermöglicht durch das Ausknicken der Kontaktstifte 5 zwischen den beiden Platten 1 und 2, wie Figur 2 zeigt. Hierbei wird die Kontaktierkraft über die obere Platte 1 auf die Kontaktstifte 5 übertragen. Wie zuvor ausgeführt, sind die aus der oberen Platte 1 hervorstehenden Enden elektrisch mit einer geeigneten Meßeinheit verbunden.

Figur 3 bis 7 zeigen weitere Ausführungsbeispiele, wobei gleichwirkende Teil mit gleichen Bezugsziffern wie zuvor versehen sind.

Figur 3 zeigt ein Ausführungsbeispiel, bei dem die Kontaktstifte 5 mit Hilfe einer zwischen der oberen Platte 1 und der unteren Platte 2 liegenden Lochplatte 9 elastisch vorgebogen sind. Die in der Lochplatte 9 vorgesehenen Durchgangslöcher 10 sind gegenüber den Bohrungen 4 und 6 in den beiden Platten 1 und 2 in Axialrichtung versetzt, so daß bei Anlage der Lochplatte 9 an einem Anschlag 11 die Kontaktstifte 5 elastisch vorgebogen werden. Beim Kontaktieren wandert die Lochplatte 9 in Pfeilrichtung 12 aus, wenn die Kontaktstellen 7 des Prüflings 8 mit den Kontaktstiften 5 in Verbindung treten und ein entsprechender Kontaktdruck ausgeübt wird. Wird der Prüfling 8 entfernt, so kehrt die Lochplatte 9 durch die Federwirkung der Kontaktstifte 5 in ihrer Ausgangslage wiederum zurück. Durch Verwendung eines in Pfeilrichtung 12 verstellbaren Anschlages 11, kann Vorspannung der Kontaktstifte eingestellt werden. Diese Ausführungsform ist deshalb vorteilhaft, weil durch die Lochplatte 9 verhindert wird, daß sich die Kontaktstifte 5 gegenseitig berühren. Ferner wird durch die Platte 9 ein Kontaktkraftausgleich zwischen den einzelnen Kontaktstiften erreicht.

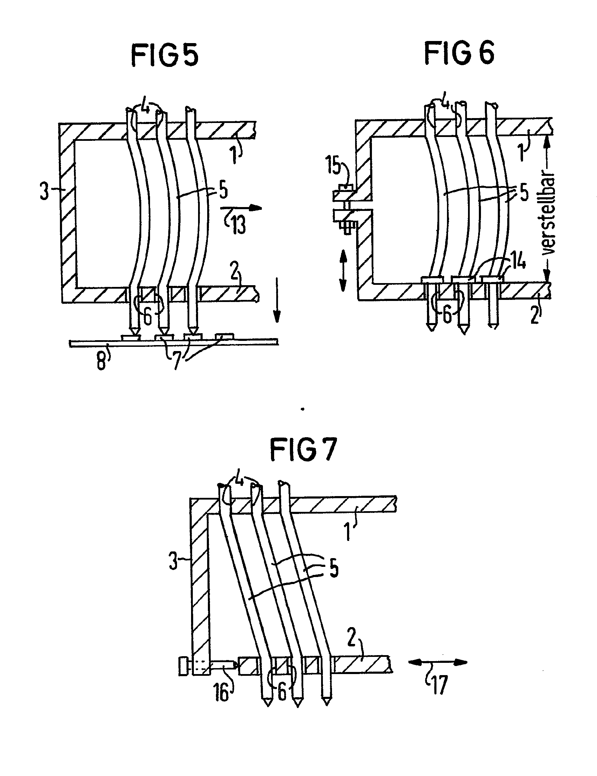

Figur 4 zeigt ein Ausführungsbeispiel, bei dem die unbelasteten Kontaktstifte 5 plastisch gebogen sind, so daß bei der Kontaktierung die Kontaktstifte 5 in Pfeilrichtung 13 auswandern können, wie in Figur 5 dargestellt ist.

Bei dem Ausführungsbeispiel nach Figur 6 sind die Kontaktstifte 5 elastisch vorgespannt und zwar dadurch, daß die
Kontaktstifte 5 einen Kragen 14 aufweisen, der sich gegen
den oberen Rand der Bohrungen 6 in der unteren Platte 2
legt. Dadurch, daß die obere Platte 1 mit der unteren
Platte 2 nicht fest, sondern über eine Schraubenverbindung
15 verbunden ist, kann der Abstand zwischen den Platten 1
und 2 und damit auch die Vorspannung der Kontaktstifte 5
geändert werden.

Figur 7 zeigt ein Ausführungsbeispiel, bei dem die Kontaktstifte 5 durch Verschieben der unteren Platte 2 elastisch
gebogen werden. Die Verschiebung der Platte 2 gegenüber
dem Verbindungsstück 3 wird mit Hilfe einer Schraube 16
vorgenommen, und zwar in Pfeilrichtung 17. Dadurch, daß
die Kontaktstifte 5 in den hochgenau gefertigten Bohrungen
6 geführt sind, treten die Enden der Kontaktstifte 5 mehr
oder weniger normal aus der unteren Platte 2 hervor.

Wie zuvor ausgeführt, ist es erwünscht, daß die Kontaktstifte 5 voneinander isoliert angeordnet sind. Dies kann
dadurch erreicht werden, daß die Platten 1 und 2 aus
Isoliermaterial bestehen oder die Oberfläche der Kontaktstifte 5 zumindest an der mit den Platten in Berührung
kommenden Stellen mit einem Überzug aus Isoliermaterial
versehen sind.

10 Patentansprüche
 7 Figuren

Patentansprüche

1. Vorrichtung zum gleichzeitigen Kontaktieren mehrerer eng beisammenliegender Prüfpunkte, insbesondere Rasterfelder mit kleinen Rasterabständen, mit Hilfe von in axialer Richtung federnden Kontaktstiften, die in einer Platte oder dgl. längsbeweglich und unter Federwirkung stehend entsprechend dem Rasterfeld oder dgl. angeordnet sind, dadurch g e k e n n z e i c h n e t , daß die Kontaktstifte (5) in Bezug auf ihre Länge extrem dünn ausgebildet sind und aus Federmetall bestehen und daß die in axialer Richtung wirkende Federkraft für jeden der Kontaktstifte (5) durch Ausknicken und/oder Ausfedern der Kontaktstifte (5) senkrecht zu ihrer axialen Bewegungsrichtung (Längsrichtung) beim Aufsetzen der Kontaktstifte (5) auf das Rasterfeld aufgebracht wird.

2. Vorrichtung nach Anspruch 1, dadurch g e k e n n - z e i c h n e t , daß die Kontaktstifte (5) zumindest vor dem Aufsetzen auf das Rasterfeld senkrecht zu ihrer axialen Bewegungsrichtung (Längsrichtung) elastisch vorbiegbar sind.

3. Vorrichtung nach Anspruch 1, dadurch g e k e n n - z e i c h n e t , daß die Kontaktstifte (5) senkrecht zu ihrer axialen Bewegungsrichtung (Längsrichtung) plastisch vorgebogen sind.

4. Vorrichtung nach einem der Ansprüche 1 bis 3, dadurch g e k e n n z e i c h n e t , daß sie mindestens zwei miteinander in Verbindung stehende, parallel zueinander angeordnete Platten (1, 2) aufweist, wobei die Kontaktstifte (5) am hinteren Ende entsprechend dem Rasterfeld in der einen (oberen) Platte (1) festgelegt und am vorderen Ende in der anderen (unteren) Platte (2) durch ent-

0068270

sprechend ausgebildete Bohrungen (6) längsbeweglich geführt sind.

5. Vorrichtung nach Anspruch 4, dadurch g e k e n n - z e i c h n e t , daß der Abstand der Platten (1,2) voneinander veränderbar ist.

6. Vorrichtung nach Anspruch 4 oder 5, dadurch g e - k e n n z e i c h n e t , daß die Kontaktstifte (5) unter Vorspannungen zwischen den Platten (1, 2) eingesetzt sind.

7. Vorrichtung nach Anspruch 6, dadurch g e k e n n - z e i c h n e t , daß die Kontaktstifte (5) mit Hilfe einer weiteren sich zwischen den beiden Platten (1, 2) befindlichen Lochplatte (9) axial vorspannbar sind.

8. Vorrichtung nach Anspruch 6, dadurch g e k e n n - z e i c h n e t , daß die Kontaktstifte (5) am vorderen Ende einen Kragen (14) aufweisen, welcher sich am Rand der Bohrungen (6) in der Unterplatte abstützt.

9. Vorrichtung nach einem der Ansprüche 1 bis 8, dadurch g e k e n n z e i c h n e t , daß die Kontaktstifte (5) voneinander elektrisch isoliert angeordnet sind.

10. Vorrichtung nach Anspruch 9, dadurch g e k e n n - z e i c h n e t , daß die Platten (1, 2) aus Isoliermaterial bestehen oder die Oberfläche der Kontaktstifte (5) zumindest an der mit den Platten in Berührung kommenden Stelle mit einem Überzug aus Isoliermaterial versehen sind.

Bezugszeichenliste

| | |
|---|---|
| 1 | obere Platte |
| 2 | unter Platte |
| 3 | Verbindungsstück |
| 4 | Bohrungen |
| 5 | Kontaktstifte |
| 6 | Bohrungen |
| 7 | Kontaktstellen |
| 8 | Prüfling |
| 9 | Lochplatte |
| 10 | Durchgangslöcher |
| 11 | Anschlag |
| 12 | Pfeilrichtung |
| 13 | " |
| 14 | Kragen |
| 15 | Schraubenverbindung |
| 16 | Schraube |
| 17 | Pfeilrichtung |

FIG 1

FIG 2

FIG 3

FIG 4

FIG 5

FIG 6

verstellbar

FIG 7

Europäisches
Patentamt

**EUROPÄISCHER RECHERCHENBERICHT**

0068270
Nummer der Anmeldung

EP 82 10 5199

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-3 569 789 (SIEMENS) <br><br> * Figur 3; Spalte 4, Zeilen 1-5 * <br><br> --- | 1,3,4, 6,9 | H 01 R 23/72 <br> G 01 R 1/07 |
| A | US-A-3 806 801 (IBM CORP.) <br><br> * Figuren 1,4; Spalte 4, Zeilen 9-42; Anspruch 1 * <br><br> --- | 1-4,6, 9,10 | |
| X | IBM TECHNICAL DISCLOSURE BULLETIN, Band 18, Nr. 3, August 1975, Seiten 749-750, New York, USA <br> R.M. MORTON et al.: "High-performance AC chip contactor" * Figur 2; Seite 750, Zeilen 13-15 * <br><br> --- | 1,4,8, 9 | |
| A | IEEE TRANSACTIONS ON MAGNETICS, Band MAG-17, Nr. 1, Januar 1981, Seiten 761-763, New York, USA <br> P.A. MOSKOWITZ: "Electrical performance of high density probe array for testing Josephson circuit chips" * Figur 1; Seite 761, Spalte 2, Zeilen 1-13 * <br><br> --- | 1,2,4, 6,9 | **RECHERCHIERTE SACHGEBIETE (Int. Cl. ³)** <br><br> H 01 R 13/00 <br> H 01 R 23/00 <br> G 01 R 1/00 |
| A | IBM TECHNICAL DISCLOSURE BULLETIN, Band 23, Nr. 10, März 1981, Seiten 4391-4393, New York, USA <br> A.H. BAUMAN et al.: "Electrical connectors" * Figur 2; Seite 4392, Zeilen 12-23 * <br><br> --- | 1 | |

-/-

Der vorliegende Recherchenbericht wurde für alle Patentansprüche erstellt.

| Recherchenort | Abschlußdatum der Recherche | Prüfer |
|---|---|---|
| DEN HAAG | 05-10-1982 | WAERN G.M. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03.82

Europäisches
Patentamt

**EUROPÄISCHER RECHERCHENBERICHT**

0068270
Nummer der Anmeldung

EP 82 10 5199

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | US-A-4 027 935  (IBM CORP.)<br><br>* Figuren 1,2; Spalte 2, Zeilen 50-65; Spalte 3, Zeile 41 - Spalte 4, Zeile 8 *<br><br>----- | 1,3,4, 6,9,10 | |
| | | | RECHERCHIERTE SACHGEBIETE (Int. Cl. ³) |

Der vorliegende Recherchenbericht wurde für alle Patentansprüche erstellt.

| Recherchenort | Abschlußdatum der Recherche | Prüfer |
|---|---|---|
| DEN HAAG | 05-10-1982 | WAERN G.M. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82